# EUROPEAN PATENT APPLICATION

(11) **EP 4 761 054 A1**
(43) Date of publication of application: **17.06.2026**
(21) Application number: 25219054.1
(22) Date of filing: 27.11.2025
(51) Int. Cl.: H02J 7/50, H02J 7/96

(54) **BATTERY CHARGING CONTROL SYSTEMS FOR AIRCRAFT BATTERIES**

(30) Priority: 27.11.2024 US 202418962586
(71) Applicant: Pratt & Whitney Canada Corp., (01BE5) Longueuil, QC J4G 1A1 (CA)
(72) Inventor: GARIEPY, Raphael, J4G 1A1 (01BE5) Longueuil (CA); SHENOUDA, Antwan, J4G 1A1 (01BE5) Longueuil (CA); ROBACHE, Remi, J4G 1A1 (01BE5) Longueuil (CA); KHARAL, Fraz Ahmad, J4G 1A1 (01BE5) Longueuil (CA); JARVO, James, J4G 1A1 (01BE5) Longueuil (CA); MESHKINFAM, Ezzat, J4G 1A1 (01BE5) Longueuil (CA); FLYNN, Manon, J4G 1A1 (01BE5) Longueuil (CA)
(74) Representative: Dehns

(57) **Abstract**

A propulsion system (20) for an aircraft (1000) includes a battery (64), an electrical distribution system (66), a charger, and a battery management system (68). The battery includes a plurality of battery strings including a first battery string. Each of the plurality of battery strings includes a plurality of battery cells. The battery management system includes a battery sensor assembly and a battery management system (BMS) controller. The battery sensor assembly includes a plurality of battery cell voltage sensors. The BMS controller is configured to control the charger to charge the battery, including at least the first battery string, by executing a battery charging profile including a target charging voltage, measure a cell voltage of each of the plurality of battery cells of the first battery string, and identify correlation or non-correlation of a charging voltage applied by the charger with the target charging voltage.

## Description

### TECHNICAL FIELD

This disclosure relates generally to aircraft electrical systems including batteries and, more particularly, to controls systems for facilitating battery charging.

### BACKGROUND OF THE ART

Propulsion system architectures for aircraft, such as hybrid-electric propulsion systems, may typically include one or more electrical assemblies configured to support various functions of the propulsion system and an associated aircraft. These electrical assemblies may frequently include batteries configured to provide electrical power for various electrical loads of the aircraft and its propulsion system(s). Various systems and methods for charging these batteries are known. While these known systems and methods may be suitable for their intended purposes, there is always room in the art for improvement.

### SUMMARY

It should be understood that any or all of the features or embodiments described herein can be used or combined in any combination with each and every other feature or embodiment described herein unless expressly noted otherwise.

According to an aspect of the present disclosure, a propulsion system for an aircraft includes a battery, an electrical distribution system, a ground-based charger, and a battery management system. The battery includes a plurality of battery strings. The plurality of battery strings includes a first battery string. Each of the plurality of battery strings includes a plurality of battery cells electrically connected together in series. The electrical distribution system includes a battery string switch assembly. The battery string switch assembly is operable to electrically interconnect each of the plurality of battery strings together in parallel. The ground-based charger is electrically connected to the electrical distribution system. The battery management system includes a battery sensor assembly and a battery management system (BMS) controller. The battery sensor assembly includes a plurality of battery cell voltage sensors. The BMS controller is connected in signal communication with the battery sensor assembly and the ground-based charger. The BMS controller includes a processor connected in signal communication with a non-transitory memory storing instructions which, when executed by the processor, cause the processor to: control the ground-based charger to charge the battery, including at least the first battery string, by executing a battery charging profile including a target charging voltage and a target charging current, measure a cell voltage of each of the plurality of battery cells of the first battery string with a respective one of the plurality of battery cell voltage sensors while charging the battery, and identify correlation or non-correlation of a charging voltage applied by the ground-based charger to the electrical distribution system with the target charging voltage using the cell voltage of each of the plurality of battery cells of the first battery string.

In any of the above and herein, the instructions, when executed by the processor, may further cause the processor to determine the battery charging profile specific to the battery using battery data for the battery, and controlling the ground-based charger to charge the battery may include controlling the ground-based charger to apply the target charging voltage and the target charging current to the electrical distribution system.

In any of the above and herein, identifying correlation or non-correlation of the charging voltage may include determining an estimated string voltage using a first cell voltage of a first battery cell of the plurality of battery cells of the first battery string and a quantity of the plurality of battery cells of the first battery string and identifying correlation of the charging voltage where the estimated string voltage is within a voltage threshold of the target charging voltage and non-correlation of the charging voltage where the estimated string voltage is outside of the voltage threshold of the target charging voltage.

In any of the above and herein, identifying correlation or non-correlation of the charging voltage may include identifying a first battery cell of the plurality of battery cells of the first battery string having a maximum cell voltage of the plurality of battery cells of the first battery string, identifying a second battery cell of the plurality of battery cells of the first battery string having a minimum cell voltage of the plurality of battery cells of the first battery string, determining a maximum estimated string voltage using the maximum cell voltage and a quantity of the plurality of battery cells of the first battery string and determining a minimum estimated string voltage using the minimum cell voltage and the quantity of the plurality of battery cells of the first battery string, and identifying correlation of the charging voltage where the maximum estimated string voltage is within a first voltage threshold of the target charging voltage and the minimum estimated string voltage is within a second voltage threshold of the target charging voltage and non-correlation of the charging voltage where the maximum estimated string voltage is outside of the first voltage threshold or the minimum estimated string voltage is outside of the second voltage threshold.

In any of the above and herein, identifying correlation or non-correlation of the charging voltage may include determining an estimated string voltage by summing a cell voltage of each of the plurality of battery cells of the first battery string and identifying correlation of the charging voltage where the estimated string voltage is within a voltage threshold of the target charging voltage and non-correlation of the charging voltage where the estimated string voltage is outside of the voltage threshold of the target charging voltage.

In any of the above and herein, the battery sensor assembly may further include a string current sensor for the first battery string and a plurality of cell temperature sensors, the instructions, when executed by the processor, may further cause the processor to measure a cell temperature of each of the plurality of battery cells of the first battery string with a respective one of the plurality of battery cell voltage sensors while charging the battery and measure a string current of the first battery string with the string current sensor, and identifying correlation or non-correlation of the charging voltage may include identifying a first battery cell of the plurality of battery cells of the first battery string having a maximum cell voltage of the plurality of battery cells of the first battery string, and identifying a maximum current threshold using the maximum cell voltage and a first cell temperature of the first battery cell, identifying a second battery cell of the plurality of battery cells of the first battery string having a minimum cell voltage of the plurality of battery cells of the first battery string, and identifying a minimum current threshold using the minimum cell voltage and a second cell temperature of the second battery cell, and identifying correlation of the charging voltage where the string current is between the maximum current threshold and the minimum current threshold and non-correlation of the charging voltage where the string current is outside of the maximum current threshold and the minimum current threshold.

In any of the above and herein, the instructions, when executed by the processor, may further cause the processor to generate a warning in response to identification of the non-correlation of the charging voltage while charging the battery.

In any of the above and herein, the instructions, when executed by the processor, may further cause the processor to control the battery string switch assembly to electrically disconnect the plurality of battery strings from the ground-based charger in response to identification of the non-correlation of the charging voltage while charging the battery.

In any of the above and herein, the instructions, when executed by the processor, may further cause the processor to control the ground-based charger to terminate the battery charge in response to identification of the non-correlation of the charging voltage while charging the battery.

In any of the above and herein, the instructions, when executed by the processor, may further cause the processor to determine a lower-power battery charging profile, in response to identification of the non-correlation of the charging voltage while charging the battery, and control the ground-based charger to charge the battery by supplying electrical power to the electrical distribution system at a target second voltage and a target second current defined by the lower-power battery charging profile.

According to another aspect of the present disclosure, a method for charging a battery for an aircraft propulsion system includes electrically interconnecting a ground-based charger with the battery through an electrical distribution system for the aircraft propulsion system, the battery including a plurality of battery strings, the plurality of battery strings including a first battery string, each of the plurality of battery strings including a plurality of battery cells electrically connected together in series, the electrical distribution system including a battery string switch assembly, the battery string switch assembly operable to electrically interconnect each of the plurality of battery strings together in parallel, determining, at a battery management system (BMS) controller of a battery management system for the battery, a battery charging profile specific to the battery, the battery charging profile including a target charging voltage and a target charging current, charging the battery by controlling the ground-based charger with the BMS controller to supply electrical power to the electrical distribution system at the target charging voltage and the target charging current, and identifying, at the BMS controller, correlation or non-correlation of a charging voltage applied by the ground-based charger to the electrical distribution system with the target charging voltage using a cell voltage of each of the plurality of battery cells of the first battery string.

In any of the above and herein, identifying correlation or non-correlation of the charging voltage may include determining, at the BMS controller, an estimated string voltage using a first cell voltage of a first battery cell of the plurality of battery cells of the first battery string and a quantity of the plurality of battery cells of the first battery string and identifying, at the BMS controller, correlation of the charging voltage where the estimated string voltage is within a voltage threshold of the target charging voltage and non-correlation of the charging voltage where the estimated string voltage is outside of the voltage threshold of the target charging voltage.

In any of the above and herein, identifying correlation or non-correlation of the charging voltage may include identifying, at the BMS controller, a first battery cell of the plurality of battery cells of the first battery string having a maximum cell voltage of the plurality of battery cells of the first battery string, identifying, at the BMS controller, a second battery cell of the plurality of battery cells of the first battery string having a minimum cell voltage of the plurality of battery cells of the first battery string, determining, at the BMS controller, a maximum estimated string voltage using the maximum cell voltage and a quantity of the plurality of battery cells of the first battery string and determining a minimum estimated string voltage using the minimum cell voltage and the quantity of the plurality of battery cells of the first battery string, and identifying, at the BMS controller, correlation of the charging voltage where the maximum estimated string voltage is within a first voltage threshold of the target charging voltage and the minimum estimated string voltage is within a second voltage threshold of the target charging voltage and non-correlation of the charging voltage where the maximum estimated string voltage is outside of the first voltage threshold or the minimum estimated string voltage is outside of the second voltage threshold.

In any of the above and herein, identifying correlation or non-correlation of the charging voltage may include determining, at the BMS controller, an estimated string voltage by summing a cell voltage of each of the plurality of battery cells of the first battery string and identifying, at the BMS controller, correlation of the charging voltage where the estimated string voltage is within a voltage threshold of the target charging voltage and non-correlation of the charging voltage where the estimated string voltage is outside of the voltage threshold of the target charging voltage.

In any of the above and herein, the method may further include measuring, at the BMS controller, a cell temperature of each of the plurality of battery cells of the first battery string with a respective one of the plurality of battery cell voltage sensors while charging the battery and measure a string current of the first battery string with the string current sensor, and identifying correlation or non-correlation of the charging voltage may include identifying, at the BMS controller, a first battery cell of the plurality of battery cells of the first battery string having a maximum cell voltage of the plurality of battery cells of the first battery string, and identifying a maximum current threshold using the maximum cell voltage and a first cell temperature of the first battery cell, identifying, at the BMS controller, a second battery cell of the plurality of battery cells of the first battery string having a minimum cell voltage of the plurality of battery cells of the first battery string, and identifying a minimum current threshold using the minimum cell voltage and a second cell temperature of the second battery cell, and identifying, at the BMS controller, correlation of the charging voltage where the string current is between the maximum current threshold and the minimum current threshold and non-correlation of the charging voltage where the string current is outside of the maximum current threshold and the minimum current threshold.

According to another aspect of the present disclosure, which the Applicant expressly reserves the right to claim independently, a propulsion system for an aircraft includes a battery, an electrical distribution system, and a battery management system. The battery includes a plurality of battery strings. The plurality of battery strings includes a first battery string. Each of the plurality of battery strings includes a plurality of battery cells electrically connected together in series. The electrical distribution system includes a battery string switch assembly. The battery string switch assembly is operable to electrically interconnect each of the plurality of battery strings together in parallel. The battery management system includes a battery sensor assembly and a battery management system (BMS) controller. The battery sensor assembly includes a plurality of battery cell voltage sensors. The BMS controller is connected in signal communication with the battery sensor assembly. The BMS controller includes a processor connected in signal communication with a non-transitory memory storing instructions which, when executed by the processor, cause the processor to communicate with a ground-based charger electrically connected to the electrical distribution system, control the ground-based charger to charge the battery, including at least the first battery string, by executing a battery charging profile including a target charging voltage and a target charging current, measure a cell voltage of each of the plurality of battery cells of the first battery string with a respective one of the plurality of battery cell voltage sensors while charging the battery, and verify correlation or non-correlation of a charging voltage applied by the ground-based charger to the electrical distribution system with the target charging voltage using the cell voltage of each of the plurality of battery cells of the first battery string.

In any of the above and herein, identifying correlation or non-correlation of the charging voltage may include determining an estimated string voltage using a first cell voltage of a first battery cell of the plurality of battery cells of the first battery string and a quantity of the plurality of battery cells of the first battery string and identifying correlation of the charging voltage where the estimated string voltage is within a voltage threshold of the target charging voltage and non-correlation of the charging voltage where the estimated string voltage is outside of the voltage threshold of the target charging voltage.

In any of the above and herein, identifying correlation or non-correlation of the charging voltage may include identifying a first battery cell of the plurality of battery cells of the first battery string having a maximum cell voltage of the plurality of battery cells of the first battery string, identifying a second battery cell of the plurality of battery cells of the first battery string having a minimum cell voltage of the plurality of battery cells of the first battery string, determining a maximum estimated string voltage using the maximum cell voltage and a quantity of the plurality of battery cells of the first battery string and determining a minimum estimated string voltage using the minimum cell voltage and the quantity of the plurality of battery cells of the first battery string, and identifying correlation of the charging voltage where the maximum estimated string voltage is within a first voltage threshold of the target charging voltage and the minimum estimated string voltage is within a second voltage threshold of the target charging voltage and non-correlation of the charging voltage where the maximum estimated string voltage is outside of the first voltage threshold or the minimum estimated string voltage is outside of the second voltage threshold.

In any of the above and herein, identifying correlation or non-correlation of the charging voltage may include determining an estimated string voltage by summing a cell voltage of each of the plurality of battery cells of the first battery string and identifying correlation of the charging voltage where the estimated string voltage is within a voltage threshold of the target charging voltage and non-correlation of the charging voltage where the estimated string voltage is outside of the voltage threshold of the target charging voltage.

In any of the above and herein, the battery sensor assembly may further include a string current sensor for the first battery string and a plurality of cell temperature sensors, the instructions, when executed by the processor, may further cause the processor to measure a cell temperature of each of the plurality of battery cells of the first battery string with a respective one of the plurality of battery cell voltage sensors while charging the battery and measure a string current of the first battery string with the string current sensor, and identifying correlation or non-correlation of the charging voltage may include identifying a first battery cell of the plurality of battery cells of the first battery string having a maximum cell voltage of the plurality of battery cells of the first battery string, and identifying a maximum current threshold using the maximum cell voltage and a first cell temperature of the first battery cell, identifying a second battery cell of the plurality of battery cells of the first battery string having a minimum cell voltage of the plurality of battery cells of the first battery string, and identifying a minimum current threshold using the minimum cell voltage and a second cell temperature of the second battery cell, and identifying correlation of the charging voltage where the string current is between the maximum current threshold and the minimum current threshold and non-correlation of the charging voltage where the string current is outside of the maximum current threshold and the minimum current threshold.

The present disclosure, and all its aspects, embodiments and advantages associated therewith will become more readily apparent in view of the detailed description provided below, including the accompanying drawings.

### DESCRIPTION OF THE DRAWINGS

FIG. 1 illustrates an aircraft including a propulsion system, in accordance with one or more embodiments of the present disclosure.
FIG. 2 schematically illustrates a cutaway, side view of an aircraft propulsion system, in accordance with one or more embodiments of the present disclosure.
FIG. 3 schematically illustrates a battery string for a battery, in accordance with one or more embodiments of the present disclosure.
FIG. 4 schematically illustrates an electrical assembly for an aircraft propulsion system, in accordance with one or more embodiments of the present disclosure.
FIG. 5 illustrates a block diagram depicting a control channel, in accordance with one or more embodiments of the present disclosure.
FIG. 6 illustrates an exemplary battery cell charging profile, in accordance with one or more embodiments of the present disclosure.

### DETAILED DESCRIPTION

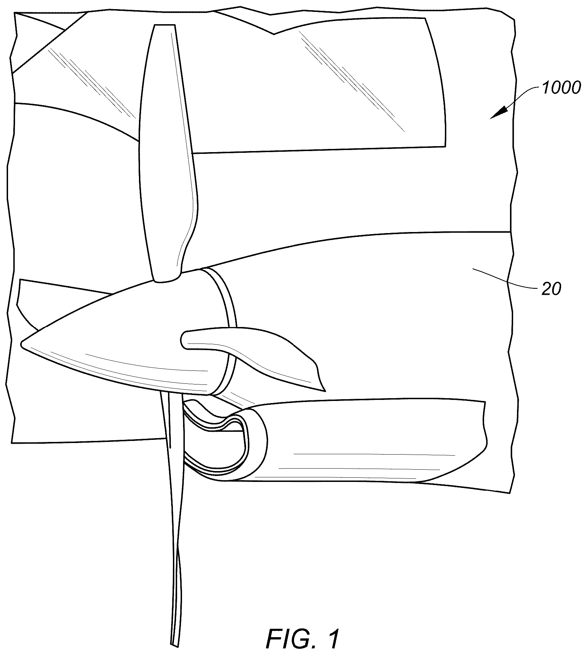

FIG. 1 illustrates an aircraft 1000 including at least one propulsion system 20. Briefly, the aircraft may be a fixed-wing aircraft (e.g., an airplane), a rotary-wing aircraft (e.g., a helicopter), a tilt-rotor aircraft, a tilt-wing aircraft, or another aerial vehicle. Moreover, the aircraft may be a manned aerial vehicle or an unmanned aerial vehicle (UAV, e.g., a drone).

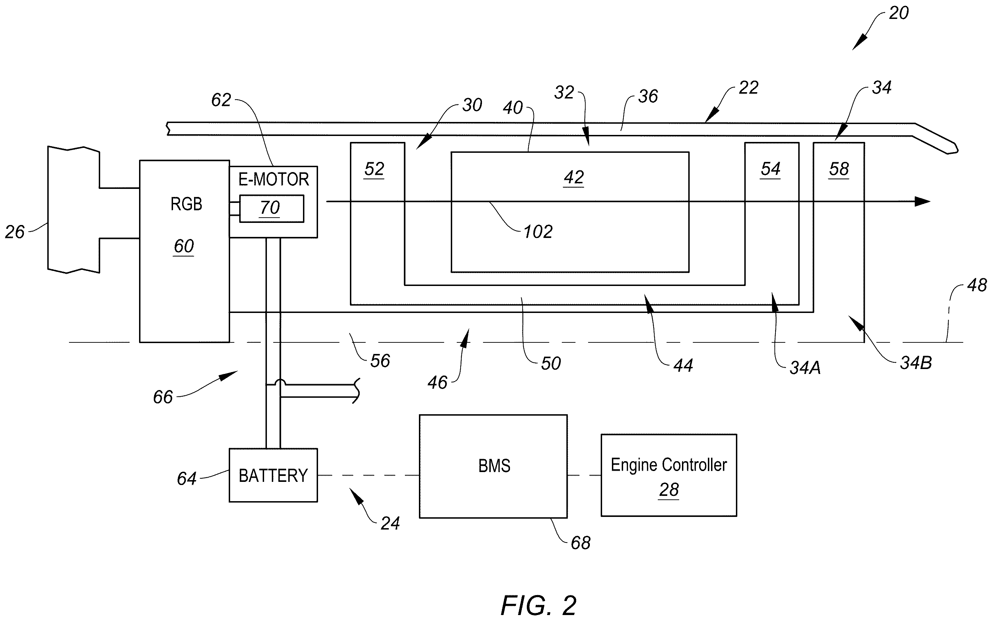

FIG. 2 schematically illustrates a cutaway, side view of the propulsion system 20. The propulsion system 20 of FIG. 2 includes an engine 22, an electrical assembly 24, a propulsor 26, and an engine controller 28. The engine 22 of FIG. 2 is configured as a turboprop gas turbine engine. However, the present disclosure is not limited to any particular configuration of gas turbine engine for the propulsion system 20, and examples of gas turbine engine configurations for the propulsion system 20 may include, but are not limited to, a turbofan engine, a turbojet engine, a propfan engine, or the like. Aspects of the present disclosure may be equally applicable to aircraft propulsion systems including other engine configurations such as, but not limited to, rotary engines, piston engines, and the like, or to electric aircraft propulsion systems (e.g., battery-electric propulsion systems, fuel-cell-electric propulsion systems, etc.). Aspects of the present disclosure may also be equally applicable to aircraft engines which are not part of a propulsion system, for example, an engine for an auxiliary power unit (APU).

The engine 22 of FIG. 2 includes a compressor section 30, a combustor section 32, a turbine section 34, and an engine static structure 36. The combustor section 32 includes a combustor 40 (e.g., an annular combustor). The combustor 40 forms a combustion chamber 42. The turbine section 34 includes a high-pressure turbine section 34A and a power turbine section 34B.

Components of the compressor section 30 and the turbine section 34 of FIG. 2 form a first rotational assembly 44 (e.g., a high-pressure spool) and a second rotational assembly 46 of the engine 22. The first rotational assembly 44 and the second rotational assembly 46 are mounted for rotation about a rotational axis 48 (e.g., an axial centerline) of the engine 22 relative to the engine static structure 36.

The first rotational assembly 44 includes a first shaft 50, a bladed compressor rotor 52 for the compressor section 30, and a bladed first turbine rotor 54 for the high-pressure turbine section 34A. The first shaft 50 interconnects the bladed compressor rotor 52 and the bladed first turbine rotor 54.

The second rotational assembly 46 of FIG. 2 includes a second shaft 56 and a bladed second turbine rotor 58 for the power turbine section 34B. The second shaft 56 is connected to the bladed second turbine rotor 58. The second shaft 56 operably connects (e.g., directly or indirectly connects) the bladed second turbine rotor 58 with the propulsor 26. For example, the second shaft 56 of FIG. 2 is coupled with the propulsor 26 by a gear box 60 (e.g., a reduction gear box (RGB)). The gear box 60 includes a gear assembly (e.g., an epicyclic gear assembly) coupling the second shaft 56 and the propulsor 26. The gear assembly may be a reduction gear assembly configured to drive rotation of the propulsor 26 at a reduced rotational speed relative to the second shaft 56. Of course, the second shaft 56 may alternatively be directly connected to the propulsor 26 to drive the propulsor 26 at the same rotational speed as the second shaft 56.

The engine static structure 36 includes engine casings, cowlings, and other fixed (e.g., non-rotating) structures of the engine 22 which house and/or support components of the engine 22 such as, but not limited to, those of the compressor section 30, the combustor section 32, and the turbine section 34. The engine static structure 36 includes one or more bearing assemblies and/or gear trains configured to rotationally support and/or interconnect components of the first rotational assembly 44 and the second rotational assembly 46.

The electrical assembly 24 of FIG. 2 includes an electric motor 62, a battery 64, an electrical distribution system 66, and a battery management system (BMS) 68.

The electric motor 62 is electrically connected to the electrical distribution system 66. The electric motor 62 includes a rotor 70. The rotor 70 is coupled to the propulsor 26 by the gear box 60. For example, the gear box 60 may couple both of the second shaft 56 and the rotor 70 to the propulsor 26 to facilitate driving rotation of the propulsor 26 with the bladed second turbine rotor 58 (e.g., via the second shaft 56), the electric motor 62 (e.g., the rotor 70), or a combination of the bladed second turbine rotor 58 and the electric motor 62. The electric motor 62 may additionally include a motor control unit (e.g., an inverter) configured to control electric power characteristics (e.g., frequency, voltage, current) supplied to the electric motor 62 (e.g., windings of the electric motor 62), for example, to control a rotation speed and/or torque of the rotor 70.

The battery 64 is electrically connected to the electrical distribution system 66. The battery 64 is configured to selectively supply electrical power to the electrical distribution system 66 independently (e.g., as a single power source for the electrical assembly 24) or in combination with one or more other electrical power sources (e.g., an electrical generator). As will be discussed in further detail, the battery 64 may include a plurality of battery modules (e.g., battery packs), battery cells, and/or the like electrically connected together in series and/or parallel as necessary to configure the battery 64 with the desired electrical characteristics (e.g., voltage output, current output, storage capacity, etc.). The present disclosure is not limited to any particular configuration of the battery 64. The battery 64 (e.g., and its battery cells) may be configured as a rechargeable battery having a battery chemistry such as, but not limited to, lead acid, nickel cadmium (NiCd), nickel-metal hydride (Ni-MH), lithium-ion (Li-ion), lithium-polymer (Li-poly), lithium metal, and the like. The battery 64 may be disposed, for example, in the aircraft 1000 and/or its propulsion system 20.

During operation of the propulsion system 20 of FIG. 2, ambient air enters the propulsion system 20 through an air intake into and through a core flow path of the engine 22. The ambient air flow along the core flow path is compressed in the compressor section 30 and directed into the combustor 40. Fuel is injected into the combustor 40 (e.g., the combustion chamber 42) and mixed with the compressed air to provide a fuel-air mixture. This fuel-air mixture is ignited, and combustion products thereof flow through the high-pressure turbine section 34A and the power turbine section 34B and are exhausted from the propulsion system 20. The bladed first turbine rotor 54 and the bladed second turbine rotor 58 rotationally drive the first rotational assembly 44 and the second rotational assembly 46, respectively, in response to the combustion gas flow through the high-pressure turbine section 34A and the power turbine section 34B. The second rotational assembly 46 (e.g., the second shaft 56) may drive rotation of the propulsor 26, for example, through the gear box 60. The electric motor 62 may be selectively operated (e.g., by the engine controller 28) to drive rotation of the propulsor 26 independently or in combination with the engine 22 through the gear box 60.

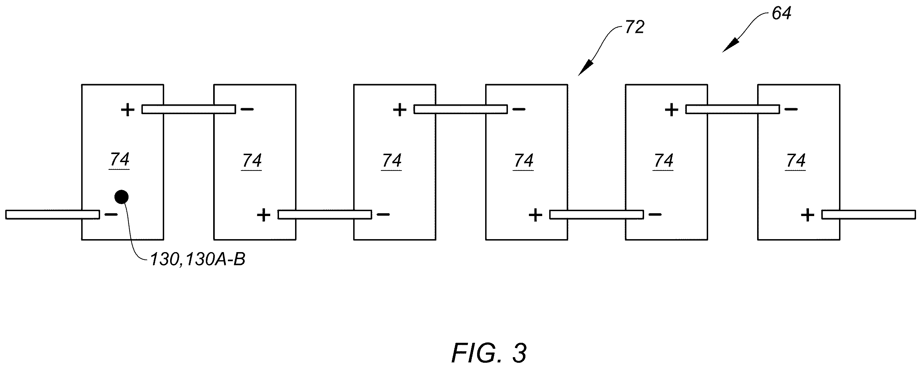

FIG. 3 schematically illustrates an exemplary battery string 72 of the battery 64. The battery string 72 of FIG. 3 includes a plurality of battery cells 74 connected in series to form the battery string 72. For example, each of the battery cells 74 of the battery string 72 may be electrically connected in series (e.g., positive to negative or negative to positive) to one or more other battery cells 74 of the battery string 72. The battery string 72 of FIG. 3 includes six (6) battery cells 74 electrically connected in series. The present disclosure, however, is not limited to any particular number of battery cells 74 for the battery string 72. The battery cells 74 may be understood to as a smallest discrete unit of the battery 64 configured to convert chemical energy to electrical energy and vice versa (e.g., each of the battery cells 74 may include a cathode, an anode, and an electrolyte). The battery cells 74 may be configured as cylindrical cells, pouch cells, prismatic cells, and the like, and the present disclosure is not limited to any particular configuration of the battery cells 74.

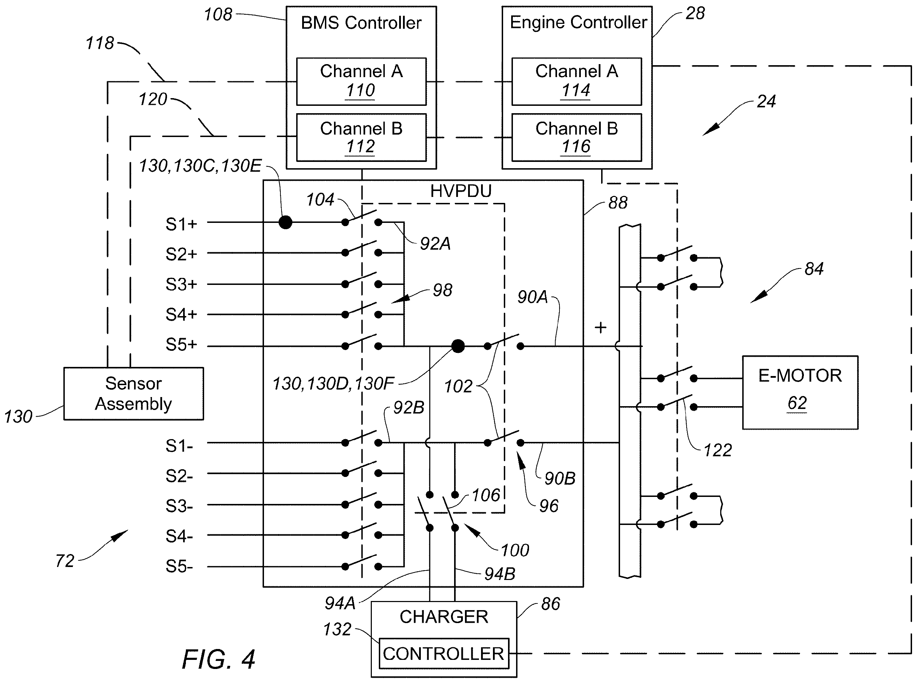

FIG. 4 schematically illustrates a portion of the electrical assembly 24 including the battery 64, the electrical distribution system 66, and the battery management system 68. The electrical assembly 24 is configured to supply electrical power to one or more electrical loads 84 (e.g., the electric motor 62) of the propulsion system 20 and/or the aircraft 1000 (see FIG. 1). The battery 64 of FIG. 4 includes a plurality of the battery strings 72 electrically connected together in parallel, for example, by the electrical distribution system 66. The plurality of battery strings 72 of FIG. 4 includes five (5) battery strings 72, S1-5 electrically connected together in parallel; however, the present disclosure is not limited to any particular quantity of battery strings 72 of the battery 64. The electrical assembly 24 further includes a charger 86 which may be selectively electrically connected with the electrical distribution system 66 to supply electrical power to charge the battery 64 and/or to facilitate operation of the electrical loads 84. The charger 86 may typically be external to the aircraft 1000 (see FIG. 1) and ground based, and may be electrically connected with the electrical distribution system 66 by electrical cables or the like.

The electrical distribution system 66 electrically interconnects components of the electrical assembly 24. The electrical distribution system 66 includes switchgear, cables, wires, breakers, switches, contactors, electrical power conditional and/or conversion (e.g., AC to DC or DC to AC conversion) components, and/or other electrical components to effect the transfer of electrical power between components of the electrical assembly 24. For example, the electrical distribution system 66 of FIG. 2 electrically connects the electric motor 62 (and other electrical loads 84 of the aircraft 1000 and/or the propulsion system 20) with the battery 64 and other electric power sources (e.g., an electrical generator) of the electrical assembly 24. The electrical distribution system 66 may additionally include one or more electrical power controllers, for example, to control a magnitude and/or direction of electrical current flow to components of the electrical assembly 24. The electrical distribution system 66 is configured to supply electrical power to the electrical loads 84 of the aircraft 1000, the propulsion system 20, and/or the engine 22.

The electrical distribution system 66 of FIG. 4 includes a high-voltage power distribution unit (HVPDU) 88. The HVPDU 88 includes a positive main battery line 90A, a negative main battery line 90B, a positive string line 92A and a negative string line 92B for each of the battery strings 72, a positive charger line 94A, and a negative charger line 94B. The main battery lines 90A, 90B electrically interconnect the battery strings 72 with the electrical loads 84 (e.g., at an electrical output of the HVPDU 88). The string battery lines 92A, 92B electrically connect each of the battery strings 72 with the main battery lines 90A, 90B. For example, the positive string lines 92A (e.g., S1+, S2+, S3+, S4+, S5+) are electrically connected together at a positive battery line 90A the negative string lines 92B (e.g., S1-, S2, S3-, S4-, S5-) electrically connected together at the negative battery line 90B to electrically connect the battery strings 72 in parallel. The charger lines 94A, 94B are configured to electrically interconnect the charger 86 with the main battery lines 90A, 90B when the charger 86 is electrically connected with the electrical distribution system 66. The HVPDU 88 further includes a main battery switch assembly 96 for the main battery lines 90A, 90B, a battery string switch assembly 98 for the string lines 92A, 92B, and a charger switch assembly 100 for the charger lines 94A, 94B.

The main battery switch assembly 96, the battery string switch assembly 98, and the charger switch assembly 100 of FIG. 4 each include electrical contactors configured to facilitate selective control of electrical current flow through the HVPDU 88, for example, along the main battery lines 90A, 90B, the string lines 92A, 92B, and the charger lines 94A, 94B. The contactors are selectively configurable (e.g., switchable) in and between a closed condition or an open condition to conduct or interrupt an electrical current flow, respectively. The contactors may include electrically-controlled relays or switches which may be controlled by an electrical control signal to position the respective contactors in the open condition or the closed condition. The present disclosure, switch assemblies 96, 98, 100, however, are not limited to electrical contactors and other electrical power interruption devices, breakers, and switches may alternatively be used. The main battery switch assembly 96, the battery string switch assembly 98, and the charger switch assembly 100 of FIG. 4 include main battery contactors 102, string contactors 104, and charger contactors 106 on each of the main battery lines 90A, 90B, the string lines 92A, 92B, and the charger lines 94A, 94B, respectively.

The battery management system 68 includes a BMS controller 108. The BMS controller 108 and/or the engine controller 28 may each be configured as a dual channel controller. For example, the BMS controller 108 of FIG. 4 includes a first control channel 110 ("Channel A") and a second control channel 112 ("Channel B"). The first control channel 110 is connected in signal communication with a first control channel 114 ("Channel A") of the engine controller 28. The second control channel 112 is connected in signal communication with a second control channel 116 ("Channel B) of the engine controller 28. Communication between the first control channel 110 and the first control channel 114 is independent of communication between the second control channel 112 and the second control channel 116. Accordingly, the first control channels 110, 114 may be understood to form a first control lane 118 and the second control channel 112, 116 may be understood to form a second control lane 120 independent of the first control lane 118.

Briefly, the engine controller 28 may control operating parameters of the engine 22 including, but not limited to, fuel flow, stator vane position (e.g., variable compressor inlet guide vane (IGV) position), compressor air bleed valve position, shaft (e.g., first shaft 50 and/or second shaft 56) torque and/or rotation speed, etc. so as to control an engine power or performance of the propulsion system 20. In some embodiments, the engine controller 28 may be part of a full authority digital engine control (FADEC) system for the propulsion system 20 and its engine 22. The engine controller 28 receives signals from the BMS controller 108 to facilitate operation and control of the engine 22 and the electrical assembly 24 by the engine controller 28 or by the engine controller 28 and the BMS controller 108 in combination.

As shown in FIG. 4, the BMS controller 108 may be connected in electrical (e.g., signal) communication with each of the main battery contactors 102, each of the string contactors 104, and each of the charger contactors 106 to control positions of the contactors 102, 104, 106 in a closed position or an open position. For example, each of the first control channel 110 and the second control channel 112 may be connected in electrical communication with the main battery contactors 102, the string contactors 104, and the charger contactors 106 such that positioning any of the contactors 102, 104, 106 in their respective closed positions requires agreement by the first control channel 110 and the second control channel 112. Electrical contactors for the electrical loads 84, such as electric motor contactors 122 for the electric motor 62, may be controlled by the engine controller 28 to facilitate operation of the electric motor 62 for propulsion.

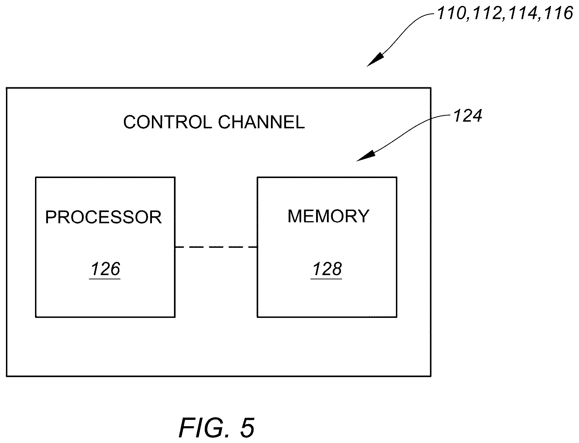

Referring briefly to FIG. 5, each of the control channels 110, 112, 114, 116 includes a discrete processing system 124. The processing system 124 includes a processor 126 connected in signal communication with memory 128. The processor 126 may include any type of computing device, computational circuit, processor(s), central processing unit (CPU), graphics processing unit (GPU), computer, or the like capable of executing a series of instructions that are stored in memory 128. Instructions can be directly executable or can be used to develop executable instructions. For example, instructions can be realized as executable or non-executable machine code or as instructions in a high-level language that can be compiled to produce executable or non-executable machine code. Further, instructions also can be realized as or can include data. Computer-executable instructions also can be organized in any format, including routines, subroutines, programs, data structures, objects, modules, applications, applets, functions, etc. The instructions may include an operating system, and/or executable software modules such as program files, system data, buffers, drivers, utilities, and the like. The executable instructions may apply to any functionality described herein to enable the processing system 124 and its processor 126 to accomplish the same algorithmically and/or coordination of electrical assembly 24 components including, but not limited to, the electric motor 62, the battery 64, the electric distribution system 66, and the battery management system 68. The memory 128 may include a single memory device or a plurality of memory devices (e.g., a computer-readable storage device that can be read, written, or otherwise accessed by a general purpose or special purpose computing device, including any processing electronics and/or processing circuitry capable of executing instructions). The present disclosure is not limited to any particular type of memory device, which may be non-transitory, and may include read-only memory, random access memory, volatile memory, non-volatile memory, static memory, dynamic memory, flash memory, cache memory, volatile or non-volatile semiconductor memory, optical disk storage, magnetic disk storage, magnetic tape, other magnetic storage devices, or any other medium capable of storing one or more instructions, and/or any device that stores digital information. The memory device(s) may be directly and/or indirectly coupled to the respective one of the engine controller 28 or the BMS controller 108. The processing system 124 may include, or may be in communication with, a user interface including one or more inputs devices and/or one or more output devices, for example, an input device that enables a user to enter data and/or instructions and an output device configured to display information (e.g., a visual display or a printer), or to transfer data, etc. Communications between the processing system 124 and external electrical or electronic devices may be via a hardwire connection or via a wireless connection. A person of skill in the art will recognize that portions of the processing system 124 may assume various forms (e.g., digital signal processor, analog device, etc.).

The battery management system 68 and its BMS controller 108 is configured to monitor conditions of the battery 64 such as, but not limited to, charging parameters, discharge parameters, state of charge, state of health, temperature, voltage, current, battery faults, arc discharges, and the like, to facilitate operation and control of the electrical assembly 24 and the battery 64. The battery management system 68 includes a battery sensor assembly 130 connected in signal communication with the BMS controller 108. The battery sensor assembly 130 includes, but is not limited to, battery cell temperature sensors 130A (e.g., for each of the battery cells 74), battery cell voltage sensors 130B (e.g., for each of the battery cells 74), string voltage sensors 130C (e.g., for each of the battery strings 72), battery voltage sensors 130D (e.g., for the battery 64), string current sensors 130E (e.g., for each of the battery strings 72), and battery current sensors 130F (e.g., for the battery 64) (see FIGS. 3 and 4). The sensors of the battery sensor assembly 130, including the sensors 130A-F, may have a redundant sensor arrangement such that each measured parameter of the battery 64 is measured independently by the first control lane 118 and the second control lane 120. For example, each of the battery cells 74 may include a first of the battery cell voltage sensors 130B connected in signal communication with the first control channel 110 and a second of the battery cell voltage sensors 130B connected in signal communication with the second control channel 112. The present disclosure, however, is not limited to the foregoing exemplary configuration of the battery sensor assembly 130.

The charger 86 of FIG. 4 includes a charger controller 132. The charger controller 132 is configured for signal communication with the BMS controller 108 when the charger 86 is electrically connected with the electrical distribution system 66. The charger controller 132 may be configured as a simple electronic hardware (SEH) system. As used herein, the term "simple electronic hardware (SEH)" refers to electronic hardware that is fully analyzable and testable. Electronic hardware may be classified as simple electronic hardware (SEH), for example, under Radio Technical Commission for Aeronautics Design Assurance Guidance for Airborne Electronic Hardware (DO-254) and/or European Organisation for Civil Aviation Equipment (EUROCAE) Design Assurance Guidance for Airborne Electronic Hardware ED-80 standards, if a comprehensive combination of deterministic tests and analyses appropriate to the design assurance level (DAL) of the electronic hardware can ensure correct functional performance under all foreseeable operating conditions with no anomalous behavior. Performance testing of simple electronic hardware (SEH) may include methods such as visual inspection, basic input-output testing, or straightforward analysis to conclusively establish that the electronic hardware performs as expected without the need for advanced analytical verification methods such as simulation or other complex analytical processes which may be necessary for complex electronic hardware (CEH). Simple electronic hardware (SEH) may typically lack complex state behavior, such as embedded processors or field-programmable gate arrays (FPGAs) with intricate logic. Simple electronic hardware (SEH) may include electronic hardware such as, but not limited to, discrete logic circuits (e.g., simple logic gates which perform only straightforward, predictable functions which can be easily analyzed and tested), signal conditioners (e.g., electronic hardware which prepares or conditions signals without modifying their fundamental characteristics), power regulators or simple power distribution circuits, basic analog circuits (e.g., operational amplifiers with a clear input-output relationship), relays and switches (e.g., mechanical or solid-state relays that control the on/off state of electrical circuits), basic communication interfaces facilitating limited data transmission (e.g., universal asynchronous receiver-transmitters (UARTs) with no advanced protocol handling), and the like. Alternatively, the charger controller 132 may include a control channel having a discrete processing system 124 (see FIG. 5).

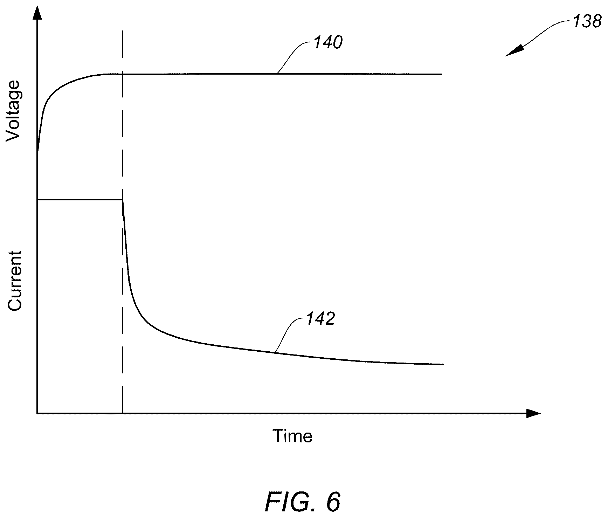

With the charger 86 electrically connected with the electrical distribution system 66 and the charger controller 132 connected in signal communication with the BMS controller 108, the BMS controller 108 (e.g., the first control channel 110 and/or the second control channel 112) may determine (e.g., select, calculate, etc.) a battery charging profile for the battery 64 based on battery data specific to the battery 64. FIG. 6 illustrates an exemplary battery charging profile 138 for the battery 64. The battery charging profile 138 includes a target charging voltage 140 and a target charging current 142 vs. time for a charging operation of the battery 64. As shown in FIG. 6, for example, the battery charging profile 138 may include initially charging the battery 64 at a constant or substantially constant current characterized by the target charging current 142. Subsequently, the battery charging profile 138 may include charging the battery 64 at a constant or substantially constant voltage, characterized by the target charging voltage 140, and with a varying (e.g., decreasing) current. The present disclosure, of course, is not limited to this foregoing exemplary battery charging profile 138. The battery data for the battery 64 may include battery data such as, but not limited to, battery 64 configuration data, battery 64 aging data, battery 64 state of charge (SoC), battery 64 voltages, battery 64 currents, battery 64 temperatures, charger 86 electrical ratings (e.g., maximum voltage and current ratings), and the like. The battery 64 configuration data may include, for example, the battery 64 type (e.g., model number), the battery 64 chemistry (e.g., lithium ion, lithium iron phosphate (LiFePO), lithium ferrophosphate (LFP), etc.), a quantity of the battery strings 72 to be charged, and/or manufacturer's voltage and current ratings for the battery 64. The battery 64 aging data may include, for example, chemical aging characteristics of the battery 64, a number of battery cycles for the battery 64, and/or a battery storage capacity of the battery 64 as a fraction of its original storage capacity. The BMS controller 108 may select one of a plurality of predetermined battery charging profiles 138 (e.g., stored in memory 128) based on the battery data. The BMS controller 108 may dynamically determine and update the battery charging profile 138 throughout the charging sequence based on battery 64 parameters from the battery sensor assembly 130. Alternatively, the BMS controller 108 may transmit the battery data for the battery 64 to the charger controller 132, and the charger controller 132 (e.g., including a control channel having a discrete processing system 124) may determine (e.g., select, calculate, etc.) the battery charging profile 138, as described above, and transmit the determined battery charging profile 138 to the BMS controller 108 (e.g., the first control channel 110 and/or the second control channel 112).

During a charging sequence, the charger 86 (e.g., the charger controller 132) may control a voltage and current output of the charger 86 applied to the battery 64 consistent with the determined battery charging profile 138 for the battery 64. However, in some rare cases, a ground-based charger for an aircraft (e.g., the charger 86) may fail to apply a charging voltage as instructed by the battery charging profile selected for the charging sequence, for example, as a result of a charger fault or other control system failure. Of particular concern, an overvoltage condition of the battery cells may increase the probability of the battery cells experiencing thermal runaway, wherein the battery cell enters an uncontrollable self-heating state. The BMS controller 108 (e.g., the first control channel 110 and/or the second control channel 112) is configured to monitor operating parameters of the battery 64 during the charging sequence to verify correlation or non-correlation of the charging voltage applied to the battery 64 by the charger 86 with the charging voltage (e.g., the target charging voltage 140) specified by the battery charging profile 138. The BMS controller 108 may monitor the operating parameters of the battery 64 at both of the first control lane 118 and the second control lane 120 to independently verify correlation or non-correlation of the charging voltage applied to the battery 64 by the charger 86 with the charging voltage specified by the battery charging profile 138.

In a first example, the BMS controller 108 (e.g., the first control channel 110 and/or the second control channel 112) may execute instructions (e.g., stored in memory 128) which cause the BMS controller 108, for one, more than one, or each of the battery cells 74 of the battery string(s) 72 undergoing the charging sequence, to measure a cell voltage, for example, with the battery cell voltage sensors 130B (see FIG. 3). For each measured cell voltage, the BMS controller 108 may multiply the measured cell voltage by a quantity of the battery cells 74 connected in series with the respective one of the battery cells 74 (e.g., a quantity of the battery cells 74 of a respective one of the battery strings 72) to determine an estimated string voltage. The BMS controller 108 may identify correlation or non-correlation of the charger 86 voltage output with the target charging voltage 140 by comparing the estimated string voltage determined for each of the battery cells 74 to the target charging voltage 140 (e.g., a target string voltage) of the battery charging profile 138. In particular, for each of the battery cells 74 having a measured cell voltage as described above, the BMS controller 108 may identify correlation of the charger 86 voltage output where the estimated string voltage is within a voltage threshold of the target charging voltage 140 or non-correlation of the charger 86 voltage output where the estimated string voltage is outside of the voltage threshold of the target charging voltage 140.

In a second example, the BMS controller 108 (e.g., the first control channel 110 and/or the second control channel 112) may additionally or alternatively execute instructions (e.g., stored in memory 128) which cause the BMS controller 108, for each of the battery cells 74 of the battery string(s) 72 undergoing the charging sequence, to measure a cell voltage, for example, with the battery cell voltage sensors 130B (see FIG. 3). Using the cell voltage for each of the battery cells 74 of a respective one of the battery strings 72, the BMS controller 108 may determine a minimum cell voltage and a maximum cell voltage for the battery string 72. The BMS controller 108 may multiply the minimum cell voltage and the maximum cell voltage by a quantity of the battery cells 74 connected in series (e.g., a quantity of the battery cells 74 of a respective one of the battery strings 72) to determine a minimum estimated string voltage and a maximum estimated string voltage. The BMS controller 108 may identify correlation or non-correlation of the charger 86 voltage output with the target charging voltage 140 by comparing the minimum cell voltage and the maximum cell voltage to the target charging voltage 140 (e.g., a target string voltage) of the battery charging profile 138. The BMS controller 108 may identify correlation of the charger 86 voltage output where the minimum cell voltage and the maximum cell voltage are within a voltage threshold (or different respective voltage thresholds) of the target charging voltage 140 or non-correlation of the charger 86 voltage output where one or both of the minimum cell voltage and the maximum cell voltage is outside of the voltage threshold of the target charging voltage 140.

In a third example, the BMS controller 108 (e.g., the first control channel 110 and/or the second control channel 112) may additionally or alternatively execute instructions (e.g., stored in memory 128) which cause the BMS controller 108 to measure a cell voltage of each of the battery cells of one, more than one, or each of the battery strings 72, for example, with the battery cell voltage sensors 130B (see FIG. 3). The BMS controller 108 may sum the cell voltages of each of the battery cells 74 connected in series within the battery string 72 to determine an estimated string voltage for the battery string 72. The BMS controller 108 may identify correlation or non-correlation of the charger 86 voltage output with the target charging voltage 140 by comparing the estimated string voltage determined for one, more than one, or each of the battery strings 72 to the target charging voltage 140 (e.g., a target string voltage) of the battery charging profile 138. In particular, the BMS controller 108 may identify correlation of the charger 86 voltage output where the estimated string voltage is within a voltage threshold of the target charging voltage 140 or non-correlation of the charger 86 voltage output where the estimated string voltage is outside of the voltage threshold of the target charging voltage 140.

In a fourth example, the BMS controller 108 (e.g., the first control channel 110 and/or the second control channel 112) may additionally or alternatively execute instructions (e.g., stored in memory 128) which cause the BMS controller 108, for each of the battery cells 74 of the battery string(s) 72 undergoing the charging sequence, to measure a cell voltage, for example, with the battery cell voltage sensors 130B (see FIG. 3). Using the cell voltage for each of the battery cells 74 of a respective one of the battery strings 72, the BMS controller 108 may determine a minimum cell voltage and a maximum cell voltage for the battery string 72. The BMS controller 108 may additionally, for each of the battery cells 74 of the battery string(s) 72 undergoing the charging sequence, measure a cell temperature, for example, with the battery cell temperature sensors 130A (see FIG. 3). The BMS controller 108 may additionally, for each of the battery strings 72 undergoing the charging sequence, measure a string current, for example, with the string current sensors 130E (see FIG. 4). Using the maximum cell voltage and the cell temperature of the battery cell 74 having the maximum cell voltage, the BMS controller 108 may calculate or otherwise identify (e.g., using a lookup table) a maximum current threshold for the respective one of the battery strings 72. Using the minimum cell voltage and the cell temperature of the battery cell 74 having the minimum cell voltage, the BMS controller 108 may calculate or otherwise identify (e.g., using a lookup table) a minimum current threshold for the respective one of the battery strings 72. The BMS controller 108 may identify correlation or non-correlation of the charger 86 voltage output with the target charging voltage 140 by comparing the measured string current of one of the battery strings 72 to the determined maximum current threshold and minimum current threshold for the respective one of the battery strings 72. The BMS controller 108 may identify correlation of the charger 86 voltage output where the measured string current is between the maximum current threshold and the minimum current threshold or non-correlation of the charger 86 voltage output where the measured string current is outside of the maximum current threshold and the minimum current threshold.

The BMS controller 108 (e.g., the first control channel 110 and/or the second control channel 112) may execute one or more protective actions in response to identifying non-correlation of the charger 86 voltage output with the target charging voltage 140. The BMS controller 108 may generate a warning (e.g., a warning light, a warning message, an audible alarm, etc.) for a pilot or other operator of the aircraft 1000 (see FIG. 1) in response to identifying improper charger 86 charging voltage control (e.g., non-correlation with the target charging voltage 140). Additionally or alternatively, the BMS controller 108 may control the battery string switch assembly 98 (e.g., the string contactors 104) and/or the charger switch assembly 100 (e.g., the charger contactors 106) to electrically isolate (e.g., deenergize) the battery strings 72 from the charger 86. Additionally or alternatively, the BMS controller 108 may transmit instructions to the charger controller 132 to terminate the battery 64 charging sequence (e.g., terminate supplying electrical power to the electrical distribution system 66). Additionally or alternatively, the BMS controller 108 may transmit instructions to the charger controller 132 to select a new (e.g., lower power) battery charging profile 138 and to supply electrical power to the electrical distribution system at the target charging voltage 140 and the target charging current 142 of the lower power battery charging profile 138.

While the principles of the disclosure have been described above in connection with specific apparatuses and methods, it is to be clearly understood that this description is made only by way of example and not as limitation on the scope of the disclosure. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this disclosure by way of reference). It is noted that these connections are general and, unless specified otherwise, may be direct or indirect and that this specification is not intended to be limiting in this respect. Any reference to attached, fixed, connected, or the like may include permanent, removable, temporary, partial, full and/or any other possible attachment option.

The terms "substantially," "about," "approximately," and other similar terms of approximation used throughout this patent application are intended to encompass variations or ranges that are reasonable and customary in the relevant field. These terms should be construed as allowing for variations that do not alter the basic essence or functionality of the invention. Such variations may include, but are not limited to, variations due to manufacturing tolerances, materials used, or inherent characteristics of the elements described in the claims, and should be understood as falling within the scope of the claims unless explicitly stated otherwise.

No element, component, or method step in the present disclosure is intended to be dedicated to the public regardless of whether the element, component, or method step is explicitly recited in the claims. As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the disclosures may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the disclosures--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements.

## Claims

1. A propulsion system (20) for an aircraft (1000), the propulsion system (20) comprising:
a battery (64) including a plurality of battery strings (72; S1-5), the plurality of battery strings (72; S1-5) including a first battery string (72, S1), each of the plurality of battery strings (72; S1-5) including a plurality of battery cells (74) electrically connected together in series;
an electrical distribution system (66) including a battery string switch assembly (98), the battery string switch assembly (98) operable to electrically interconnect each of the plurality of battery strings (72; S1-5) together in parallel;
a ground-based charger (86) electrically connected to the electrical distribution system (66); and
a battery management system (68) including a battery sensor assembly (130) and a battery management system (BMS) controller (108), the battery sensor assembly (130) including a plurality of battery cell voltage sensors (130B), the BMS controller (108) connected in signal communication with the battery sensor assembly (130) and the ground-based charger (68), the BMS controller (108) including a processor (126) connected in signal communication with a non-transitory memory (128) storing instructions which, when executed by the processor (126), cause the processor (126) to:
control the ground-based charger (68) to charge the battery (64), including at least the first battery string (72, S1), by executing a battery charging profile (138) including a target charging voltage (140) and a target charging current (142);
measure a cell voltage of each of the plurality of battery cells (74) of the first battery string (72, S1) with a respective one of the plurality of battery cell voltage sensors (130B) while charging the battery (64); and
identify correlation or non-correlation of a charging voltage applied by the ground-based charger (86) to the electrical distribution system (66) with the target charging voltage (140) using the cell voltage of each of the plurality of battery cells (74) of the first battery string (72, S1).

2. The propulsion system of claim 1, wherein the instructions, when executed by the processor (126), further cause the processor (126) to determine the battery charging profile (138) specific to the battery (64) using battery data for the battery (64), wherein controlling the ground-based charger (86) to charge the battery (64) includes controlling the ground-based charger (86) to apply the target charging voltage (140) and the target charging current (142) to the electrical distribution system (66).

3. The propulsion system of claim 1 or 2, wherein identifying correlation or non-correlation of the charging voltage includes:
determining an estimated string voltage using a first cell voltage of a first battery cell (74) of the plurality of battery cells (74) of the first battery string (72, S1) and a quantity of the plurality of battery cells (74) of the first battery string (72, S1); and
identifying correlation of the charging voltage where the estimated string voltage is within a voltage threshold of the target charging voltage (140) and non-correlation of the charging voltage where the estimated string voltage is outside of the voltage threshold of the target charging voltage (140).

4. The propulsion system of claim 1 or 2, wherein identifying correlation or non-correlation of the charging voltage includes:
identifying a first battery cell (74) of the plurality of battery cells (74) of the first battery string (72, S1) having a maximum cell voltage of the plurality of battery cells (74) of the first battery string (72, S1);
identifying a second battery cell (74) of the plurality of battery cells (74) of the first battery string (72, S1) having a minimum cell voltage of the plurality of battery cells (74) of the first battery string (72, S1);
determining a maximum estimated string voltage using the maximum cell voltage and a quantity of the plurality of battery cells (74) of the first battery string (72, S1) and determining a minimum estimated string voltage using the minimum cell voltage and the quantity of the plurality of battery cells (74) of the first battery string (72, S1); and
identifying correlation of the charging voltage where the maximum estimated string voltage is within a first voltage threshold of the target charging voltage (140) and the minimum estimated string voltage is within a second voltage threshold of the target charging voltage (140) and non-correlation of the charging voltage where the maximum estimated string voltage is outside of the first voltage threshold or the minimum estimated string voltage is outside of the second voltage threshold.

5. The propulsion system of claim 1 or 2, wherein identifying correlation or non-correlation of the charging voltage includes:
determining an estimated string voltage by summing a cell voltage of each of the plurality of battery cells (74) of the first battery string (72, S1); and
identifying correlation of the charging voltage where the estimated string voltage is within a voltage threshold of the target charging voltage (140) and non-correlation of the charging voltage where the estimated string voltage is outside of the voltage threshold of the target charging voltage (140).

6. The propulsion system of claim 1 or 2, wherein:
the battery sensor assembly (130) further includes a string current sensor (130E) for the first battery string (72, S1) and a plurality of cell temperature sensors (130A);
the instructions, when executed by the processor (126), further cause the processor (126) to measure a cell temperature of each of the plurality of battery cells (74) of the first battery string (72, S1) with a respective one of the plurality of battery cell voltage sensors (130B) while charging the battery (64) and measure a string current of the first battery string (72, S1) with the string current sensor (130E); and
identifying correlation or non-correlation of the charging voltage includes:
identifying a first battery cell (74) of the plurality of battery cells (74) of the first battery string (72, S1) having a maximum cell voltage of the plurality of battery cells (74) of the first battery string (72, S1), and identifying a maximum current threshold using the maximum cell voltage and a first cell temperature of the first battery cell (74);
identifying a second battery cell (74) of the plurality of battery cells (74) of the first battery string (72, S1) having a minimum cell voltage of the plurality of battery cells (74) of the first battery string (72, S1), and identifying a minimum current threshold using the minimum cell voltage and a second cell temperature of the second battery cell (74); and
identifying correlation of the charging voltage where the string current is between the maximum current threshold and the minimum current threshold and non-correlation of the charging voltage where the string current is outside of the maximum current threshold and the minimum current threshold.

7. The propulsion system of any preceding claim, wherein the instructions, when executed by the processor (126), further cause the processor (126) to generate a warning in response to identification of the non-correlation of the charging voltage while charging the battery (64).

8. The propulsion system of any preceding claim, wherein the instructions, when executed by the processor (126), further cause the processor (126) to control the battery string switch assembly (98) to electrically disconnect the plurality of battery strings (72; S1-5) from the ground-based charger (68) in response to identification of the non-correlation of the charging voltage while charging the battery (64).

9. The propulsion system of any preceding claim, wherein the instructions, when executed by the processor (126), further cause the processor (126) to control the ground-based charger (68) to terminate the battery charge in response to identification of the non-correlation of the charging voltage while charging the battery (64).

10. The propulsion system of any of claims 1 to 7, wherein the instructions, when executed by the processor (126), further cause the processor (126) to determine a lower-power battery charging profile, in response to identification of the non-correlation of the charging voltage while charging the battery (64), and control the ground-based charger (68) to charge the battery (64) by supplying electrical power to the electrical distribution system (66) at a target second voltage and a target second current defined by the lower-power battery charging profile.

11. A method for charging a battery (64) for an aircraft propulsion system (20), the method comprising:
electrically interconnecting a ground-based charger (68) with the battery (64) through an electrical distribution system (66) for the aircraft propulsion system (20), the battery (64) including a plurality of battery strings (72; S1-5), the plurality of battery strings (72; S1-5)including a first battery string (72, S1), each of the plurality of battery strings (72; S1-5) including a plurality of battery cells (74) electrically connected together in series, the electrical distribution system (66) including a battery string switch assembly (98), the battery string switch assembly (98) operable to electrically interconnect each of the plurality of battery strings (72; S1-5) together in parallel;
determining, at a battery management system (BMS) controller (108) of a battery management system (68) for the battery (64), a battery charging profile (138) specific to the battery (64), the battery charging profile (138) including a target charging voltage (140) and a target charging current (142);
charging the battery (64) by controlling the ground-based charger (68) with the BMS controller (108) to supply electrical power to the electrical distribution system (66) at the target charging voltage (140) and the target charging current (142); and
identifying, at the BMS controller (108), correlation or non-correlation of a charging voltage applied by the ground-based charger (68) to the electrical distribution system (66) with the target charging voltage (140) using a cell voltage of each of the plurality of battery cells (74) of the first battery string (72, S1).

12. The method of claim 11, wherein identifying correlation or non-correlation of the charging voltage includes:
determining, at the BMS controller (108), an estimated string voltage using a first cell voltage of a first battery cell (74) of the plurality of battery cells (74) of the first battery string (72, S1) and a quantity of the plurality of battery cells (74) of the first battery string (72, S1); and
identifying, at the BMS controller (108), correlation of the charging voltage where the estimated string voltage is within a voltage threshold of the target charging voltage (140) and non-correlation of the charging voltage where the estimated string voltage is outside of the voltage threshold of the target charging voltage (140).

13. The method of claim 11, wherein identifying correlation or non-correlation of the charging voltage includes:
identifying, at the BMS controller (108), a first battery cell (74) of the plurality of battery cells (74) of the first battery string (72, S1) having a maximum cell voltage of the plurality of battery cells (74) of the first battery string (72, S1);
identifying, at the BMS controller (108), a second battery cell (74) of the plurality of battery cells (74) of the first battery string (72, S1) having a minimum cell voltage of the plurality of battery cells (74) of the first battery string (72, S1);
determining, at the BMS controller (108), a maximum estimated string voltage using the maximum cell voltage and a quantity of the plurality of battery cells (74) of the first battery string (72, S1) and determining a minimum estimated string voltage using the minimum cell voltage and the quantity of the plurality of battery cells (74) of the first battery string (72, S1); and
identifying, at the BMS controller (108), correlation of the charging voltage where the maximum estimated string voltage is within a first voltage threshold of the target charging voltage (140) and the minimum estimated string voltage is within a second voltage threshold of the target charging voltage (140) and non-correlation of the charging voltage where the maximum estimated string voltage is outside of the first voltage threshold or the minimum estimated string voltage is outside of the second voltage threshold.

14. The method of claim 11, wherein identifying correlation or non-correlation of the charging voltage includes:
determining, at the BMS controller (108), an estimated string voltage by summing a cell voltage of each of the plurality of battery cells (74) of the first battery string (72, S1); and
identifying, at the BMS controller (108), correlation of the charging voltage where the estimated string voltage is within a voltage threshold of the target charging voltage (140) and non-correlation of the charging voltage where the estimated string voltage is outside of the voltage threshold of the target charging voltage (140).

15. The method of claim 11, further comprising:
measuring, at the BMS controller (108), a cell temperature of each of the plurality of battery cells (74) of the first battery string (72, S1) with a respective one of the plurality of battery cell voltage sensors (130B) while charging the battery (64) and measure a string current of the first battery string (72, S1) with a string current sensor (130E);
wherein identifying correlation or non-correlation of the charging voltage includes:
identifying, at the BMS controller (108), a first battery cell (74) of the plurality of battery cells (74) of the first battery string (72, S1) having a maximum cell voltage of the plurality of battery cells (74) of the first battery string (72, S1), and identifying a maximum current threshold using the maximum cell voltage and a first cell temperature of the first battery cell (74);
identifying, at the BMS controller (108), a second battery cell (74) of the plurality of battery cells (74) of the first battery string (72, S1) having a minimum cell voltage of the plurality of battery cells (74) of the first battery string (72, S1), and identifying a minimum current threshold using the minimum cell voltage and a second cell temperature of the second battery cell (74); and
identifying, at the BMS controller (108), correlation of the charging voltage where the string current is between the maximum current threshold and the minimum current threshold and non-correlation of the charging voltage where the string current is outside of the maximum current threshold and the minimum current threshold.
